(19) **Europäisches Patentamt**

**European Patent Office**

**Office européen des brevets**

(11) **EP 0 933 638 A2**

(12) **EUROPEAN PATENT APPLICATION**

(43) Date of publication:
04.08.1999 Bulletin 1999/31

(51) Int. Cl.⁶: $G01R\ 13/30$

(21) Application number: 99300506.5

(22) Date of filing: 25.01.1999

(84) Designated Contracting States:
AT BE CH CY DE DK ES FI FR GB GR IE IT LI LU
MC NL PT SE
Designated Extension States:
AL LT LV MK RO SI

(30) Priority: 28.01.1998 US 14640

(71) Applicant: TEKTRONIX, INC.
Wilsonville, Oregon 97070-1000 (US)

(72) Inventor: Kronschabel, Steven
Beaverton, Oregon 97006 (US)

(74) Representative:
Molyneaux, Martyn William
Langner Parry
52-54 High Holborn
London WC1V 6RR (GB)

(54) **Waveform rise/fall time cursor display**

(57) A rise/fall time cursor display computes from digitized waveform data break points in the waveform, such as 20% and 80% amplitude points. These points are connected by a straight line that is stored with the waveform data in a display memory. Short horizontal lines may be added to the cursor at the 20% and 80% amplitude points to clearly show the break points and the slope of the edge of the waveform. Further from the horizontal difference in the amplitude points and the known sample rate the actual rise/fall time is computed for alphanumeric display with the waveform.

FIG.1

**Description**

CROSS-REFERENCE TO RELATED APPLICATIONS

Not applicable

STATEMENT REGARDING FEDERALLY SPONSORED RESEARCH OR DEVELOPMENT

Not applicable

BACKGROUND OF THE INVENTION

The present invention relates to a graphics user interface, and more particularly to a rise/fall time cursor display for a digitized waveform display.

Current digital instrumentation displays waveforms in a raster scan display format. An input waveform is digitized, if not already in digital form, and stored in an acquisition memory. A controller, such as a central processing unit (CPU), transfers the digitized waveform data from the acquisition memory to a display memory where cursors are added. Some examples of cursors in a digitized waveform display are shown in U.S. Patent No. 4,751,504 issued June 14, 1988 to Keith R. Slavin entitled "Cursor Interface for Waveform Displays" and in U.S. Patent No. 4,761,640 issued August 2, 1988 to Keith R. Slavin entitled "Positioning Cursors at Specific Points on a Waveform Display." These patents show how cursors may be attached to the waveform display and used to measure parameters about the waveform displayed. Traditionally cursors are positioned either vertically or horizontally.

There are circumstances where it would be advantageous to observe how the slope of a waveform varies over time. Therefore what is desired is a tilted cursor that reflects the slope of the waveform.

SUMMARY OF THE INVENTION

Accordingly the present invention provides a rise/fall time cursor display to provide an illustration of the slope of a waveform edge. A digitized waveform is stored in a memory. From the digitized waveform a pair of specified amplitude points, such as the 20% and 80% amplitude points, is computed. A brightened line is drawn in the memory between the specified amplitude points to produce the rise/fall time cursor display. From the horizontal difference between the specified amplitude points and a known sample rate the rise/fall time may be computed and displayed together with the rise/fall time cursor on the display.

The objects, advantages and other novel features of the present invention are apparent from the following detailed description when read in conjunction with the appended claims and attached drawing.

BRIEF SUMMARY OF THE SEVERAL VIEWS OF THE DRAWING

Fig. 1 is a block diagram view of an instrument suitable for providing a rise/fall time cursor display according to the present invention.
Fig. 2 is a flow diagram view of an algorithm for providing the rise/fall cursor display according to the present invention.
Fig. 3 is a plan view of a display showing the rise/fall cursor display according to the present invention.

DETAILED DESCRIPTION OF THE INVENTION

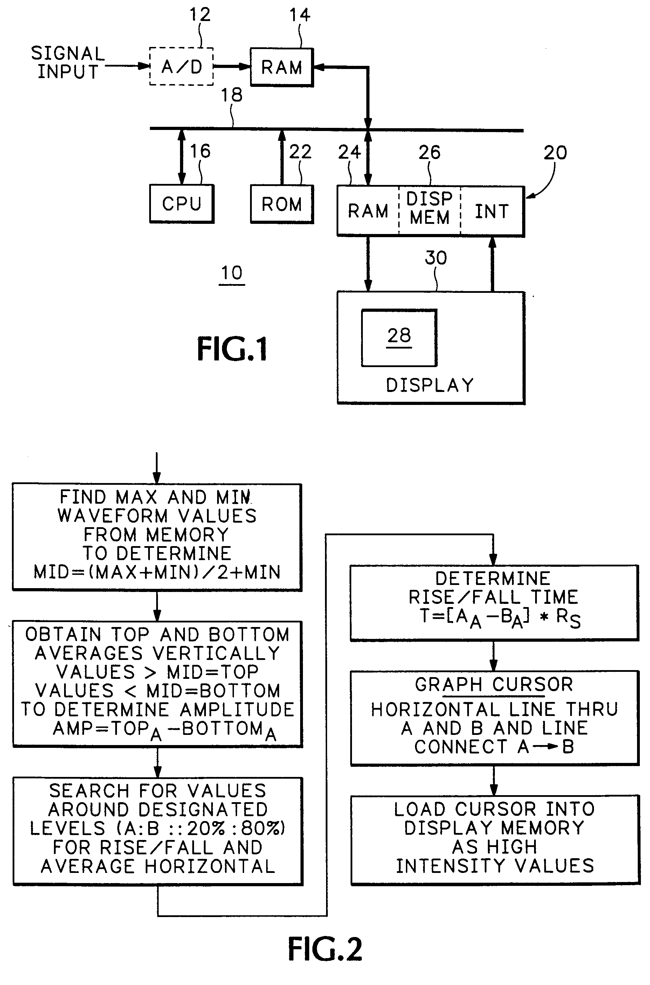

Referring now to Fig. 1 an instrument **10** is shown which receives a signal input for display. The signal input, if not already in digital form, is input to an analog to digital (A/D) converter **12** and stored in an acquisition memory **14**. The digitized waveform in the acquisition memory **14** is transferred by a central processing unit (CPU) **16** over a suitable bus **18** to a display processor **20**. The CPU **18** operates under control of a program stored in a read only memory (ROM) **22**. The digitized waveform data is accumulated in a random access memory **24** in the display processor **20** and periodically transferred to a display memory **26** to update a display **28** on an instrument front panel **30**.

An algorithm as shown in Fig. 2 is executed by the CPU **16** from ROM **22** to generate from the digitized waveform stored in the display RAM **24** appropriate cursor data to be added to the display RAM. The data is stored in the display RAM **24** with amplitude being represented by a location along the Y-axis and time being represented by a location along the X-axis. For a digital waveform most of the data lies along either the top or bottom of the display. From the waveform data in the RAM **24** the CPU **16** determines a maximum (MAX) and a minimum (MIN) amplitude value. The MAX and MIN values are used to determine a middle (MID) amplitude value: $MID = (MAX - MIN)/2 + MIN$.

TOP and BOTTOM average values are determined by comparing the amplitude values with MID and averaging those greater than MID to produce the TOP average and averaging those less than MID to produce the BOTTOM average: $TOPavg = \Sigma(Y > MID)/N$ where N is the number of TOP samples (Y > MID), and $BOTTOMavg = \Sigma(Y < MID)/M$ where M is the number of BOTTOM samples (Y < MID). The amplitude of the waveform is then the difference between TOPavg and BOTTOMavg. Particular points may now be located within the waveform that represent edges, i.e., 20% and 80% points may be located by searching horizontally for values that are $Y(20\%) = 20\%(TOPavg - BOTTOMavg) + BOTTOMavg$ or $Y(80\%) = 80\%(TOPavg - BOTTOMavg) + BOTTOMavg$. The first group of values that represent the 20% level are averaged horizontally to determine a X(20%) value, and the next group of values that represent the 80% level are averaged horizontally to determine a X(80%) value. Between these two points, (X(20%),Y(20%)) and (X(80%),Y(80%)), a straight line is computed and pixels representing the straight line are intensified in the display memory **26**. A short horizontal line through each of the two points also is intensified in the display memory **26** to indicate the end points. Each time the display memory **26** is updated from the RAM **24**, the cursor representing the slope of the edge of the waveform also is updated. The actual rise/fall time is determined by multiplying the horizontal difference between the two points representing the 20% and 80% levels on the waveform edge by the sampling rate and may also be displayed together with the waveform.

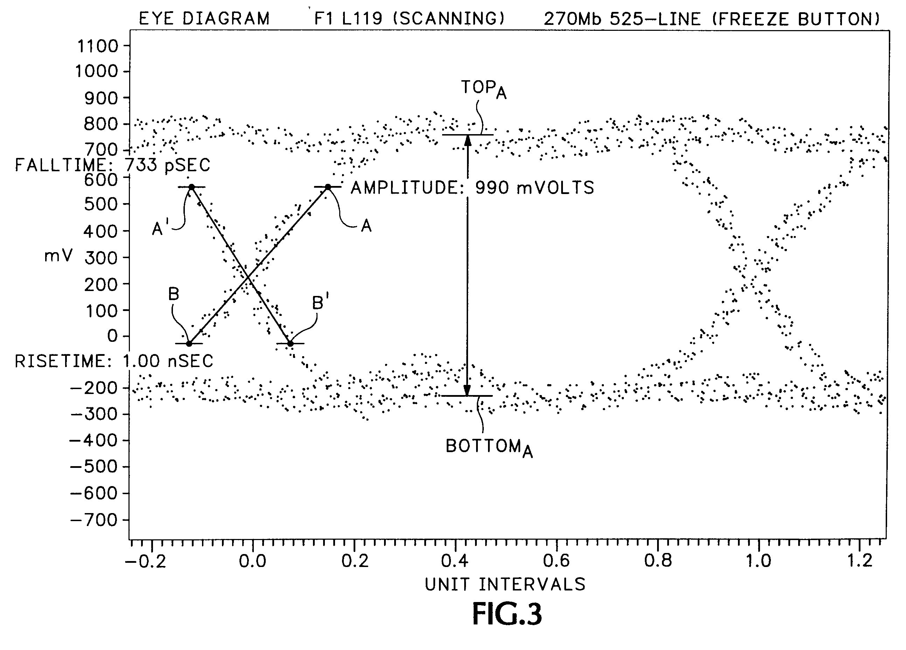

Fig. 3 illustrates a typical eye diagram display of a digital waveform. Most of the amplitude data points are located at the top and bottom of the display. For rise time cursor and time calculations the points A and B are determined, as described above, and the rise time is computed and displayed as shown. The cursor has horizontal lines through each point and a straight line connecting the two points. Likewise points A' and B' are determined for the fall time cursor and time calculation.

Thus the present invention provides a rise/fall time cursor display for observing the slope of the edges of a waveform by computing the 20% and 80% points in digitized waveform data, drawing a straight line between the points and capping the ends of the line with a short horizontal segment to produce an elongated letter "H" tilted to match the rise/fall time angles.

**Claims**

1. A method of providing a rise/fall time cursor display comprising the steps of:

   computing from digitized waveform data stored in a memory a pair of specified amplitude points;
   drawing a line in memory of a brighter intensity between the specified amplitude points to produce a rise/fall time cursor image; and
   displaying the waveform from memory with the rise/fall time cursor image.

2. The method as recited in claim 1 further comprising the steps of:

   computing from the horizontal difference between the specified amplitude points and a known sample rate a rise/fall time; and
   displaying the rise/fall time alphanumerically.

SIGNAL
INPUT → [A/D] 12 → [RAM] 14

18

[CPU] 16   [ROM] 22   [RAM | DISP MEM | INT] 24 26 20

10

FIG.1

30

[28]

DISPLAY

---

FIND MAX AND MIN
WAVEFORM VALUES
FROM MEMORY
TO DETERMINE
MID=(MAX+MIN)/2+MIN

OBTAIN TOP AND BOTTOM
AVERAGES VERTICALLY
VALUES > MID=TOP
VALUES < MID=BOTTOM
TO DETERMINE AMPLITUDE
AMP=TOP$_A$ −BOTTOM$_A$

SEARCH FOR VALUES
AROUND DESIGNATED
LEVELS (A:B ::20%:80%)
FOR RISE/FALL AND
AVERAGE HORIZONTAL

DETERMINE
RISE/FALL TIME
T=[A$_A$ −B$_A$] * R$_S$

GRAPH CURSOR
HORIZONTAL LINE THRU
A AND B AND LINE
CONNECT A→B

LOAD CURSOR INTO
DISPLAY MEMORY
AS HIGH
INTENSITY VALUES

FIG.2

4

EYE DIAGRAM      F1 L119 (SCANNING)      270Mb 525-LINE (FREEZE BUTTON)

FIG.3

EP 0 933 638 A2